# EUROPEAN PATENT SPECIFICATION

(11) **EP 2 783 399 B1**
(45) Date of publication and mention of the grant of the patent: **29.12.2021**
(21) Application number: 12850913.0
(22) Date of filing: 16.11.2012
(51) Int. Cl.: H01L 33/08, B05D 3/00, H01L 33/40, C23C 18/16, C23C 18/36, C23C 18/54, B23K 1/00, B23K 1/20, B23K 101/42, H01L 33/60

(54) **METHOD FOR TREATING METAL SURFACES**
VERFAHREN ZUR BEHANDLUNG VON METALLOBERFLÄCHEN
PROCÉDÉ DE TRAITEMENT DE SURFACES MÉTALLIQUES

(30) Priority: 22.11.2011 US 201113302362
(43) Date of publication of application: 01.10.2014
(73) Proprietor: MacDermid Acumen, Inc., Waterbury, CT 06702 (US)
(72) Inventor: TOSCANO, Lenora, M., Bristol, CT 06010 (US); LONG, Ernest, Burlingon, CT 06013 (US); PAW, Witold, Sandy Hook, CT 06482 (US); KOLOGE, Donna, Thomaston, CT 06787 (US); KOYASU, Katsutsugu, Chigasaki-shi Kanagawa 253-0054 (JP); NISHU, Keisuke, Suginami-ku Tokyo 167-0053 (JP)
(74) Representative: BRP Renaud & Partner mbB Rechtsanwälte Patentanwälte Steuerberater
(86) International application number: PCT/US2012/065419
(87) International publication number: WO 2013/078077

(56) References cited:
- WO-A1-2010/113852
- WO-A1-2012/033568
- JP-A- 2002 075 057
- US-A- 5 322 553
- US-A- 5 733 599
- US-A1- 2003 232 148
- US-A1- 2005 031 788
- US-A1- 2007 145 396
- US-A1- 2007 269 603
- US-A1- 2009 064 892
- US-A1- 2009 198 006
- None

## Description

### FIELD OF THE INVENTION

The present invention is directed to a method of treating metal surfaces to reduce corrosion thereon and/or increase reflectance of the treated metal surfaces.

### BACKGROUND OF THE INVENTION

Printed circuit board (PCB) manufacturing processes typically comprise many steps, in part because of the increasing demand for enhanced performance. Surface circuits on PCBs usually include copper and copper alloy materials that are coated to provide good mechanical and electrical connection with other devices in the assembly. In the production of printed circuit boards, a first stage comprises preparing the circuit board and a second stage comprises mounting various components on the circuit board.

There are generally two types of components that are attachable to the circuit board: a) legged components, such as resistors, transistors, etc., which are attached to the circuit board by passing each of the legs through a hole in the board and then ensuring that the hole around the leg is filled with solder; and b) surface mount devices, which are attached to the surface of the board by soldering with a flat contact area or by adhesion with a suitable adhesive.

Plated through-hole printed circuit boards may generally be fabricated by a process comprising the following sequence of steps:
1) Drill holes through copper clad laminate;
2) Process boards through standard plated through hole cycle to plate electroless copper in the holes and on the surface;
3) Apply a plating mask;
4) Electrolytically plate copper to desired thickness in the holes and on the exposed circuitry;
5) Electrolytically plate tin in holes and on exposed circuitry to serve as an etch resist;
6) Strip the plating resist;
7) Etch the exposed copper (i.e., copper not plated with tin);
8) Strip the tin;
9) Apply, image and develop a soldermask such that the soldermask covers the substantially entire board surface except for the areas of connection; and
10) Apply protective solderable layer to the areas to be soldered.

Other sequences of steps may also be used and are generally well known to those skilled in the art. In addition, fresh water rinses may be interposed between each step. Other examples of sequences of steps that may be used to prepare the printed circuit boards in the first stage are described, for example, in U.S. Pat. No. 6,319,543 to Soutar et al., U.S. Pat. No. 6,656,370 to Toscano et al., and U.S. Pat. No. 6,815,126 to Fey et al.

Solder masking is an operation in which the entire area of a printed circuit board, except solder pads, surface mount pads, and plated through-holes, is selectively covered with an organic polymer coating. The polymer coating acts like a dam around the pads to prevent the undesirable flow of solder during assembly and also improves the electrical insulation resistance between conductors and provides protection from the environment. The solder mask compound is typically an epoxy resin that is compatible with the substrate. The solder mask may be screen printed onto the printed circuit board in the desired pattern or may also be a photoimageable solder mask that is coated onto the surface.

The contact areas include wire-bonding areas, chip attach areas, soldering areas and other contact areas. Contact finishes must provide good solderability, good wire bonding performance and high corrosion resistance. Some contact finishes must also provide high conductivity, high wear resistance, and high corrosion resistance. A typical prior art contact finish coating may include an electrolytic nickel coating with an electrolytic gold layer on top, although other coatings are also known to those skilled in the art.

Soldering is generally used for making mechanical, electromechanical, or electronic connections to a variety of articles. The distinction between expected functions of the joints is important because each application has its own specific requirements for surface preparation. Of the three soldering applications, making electronic connections is the most demanding.

In the manufacture of electronic packaging devices such as printed circuit boards, connections of electronic components to a substrate are made by soldering the leads of the components to the through-holes, surrounding pads, lands and other points of connection (collectively, "Areas of Connection") on the substrate. Typically the connections occur by wave soldering techniques. The electronic packaging devices may then receive other electronic units including, for example, light emitting diodes (LEDs), which can be soldered to, for example, electrodes on a printed circuit board.

As used herein, "LED" refers to a diode that emits visible, ultraviolet, or infrared light. LEDs are solid-state light sources with many advantages. They are capable of providing light with high brightness in a reliable manner and find applications in displays, traffic lights and indicators, among others. In some embodiments, the LEDs can be assembled as an LED package with multiple LED cells arranged together on the underlying substrate and may also be coupled together in series.

One class of LEDs is fabricated from one or more Group III elements such as gallium, indium or aluminum and the Group V element of nitrogen. These III-nitride LEDs are capable of emitting light across the visible spectrum and into the ultraviolet regime of the spectrum. Other LEDs may be made from III-phosphide and III-arsenide material systems, which emit in the amber, red and infrared regions of the spectrum.

Traditionally, LEDs are fabricated by depositing an n-doped region, an active region and a p-doped region on a substrate. In modern production methods for LEDs, the light-emitting layer sequence is often first grown on a growth substrate, subsequently applied to a new carrier, and then the growth substrate is detached. This method has on the one hand the advantage that growth substrates, in particular growth substrates suitable for the production of nitride compound semiconductors, which are comparatively expensive, can be reused. This method, referred to as thin-film technology, also has the advantage that the detachment of the original substrate allows the disadvantages of the latter, such as for example a low electrical conductivity and increased absorption of the radiation generated or detected by the optoelectronic device, to be avoided.

Another technology for the production of highly efficient LEDs is a so-called "flip-chip" technology. Such a device is disclosed for example in U.S. Pat. No. 6,514,782. Described therein is a radiation-emitting semiconductor chip which is connected to a carrier substrate both by the n contact and by the p contact by means of a direct soldered connection.

Both in thin-film technology and in flip-chip technology, it is advantageous to form the contact between the semiconductor chip and the carrier substrate as a reflecting contact. In this way, penetration of the radiation generated or detected by an optoelectronic device into the contact is avoided and consequently the absorption losses are reduced.

The thin-film semiconductor body is for example connected by the electrical contact to a carrier body. In some fabrication methods, the materials of the solder layer and of the carrier body are made to match each other in such a way that they can form an alloy, in particular a eutectic alloy, that is to say no metallurgical barrier exists between the solder layer and the carrier body.

Other methods of manufacturing LEDs are described, for example in U.S. Pat. Pub. No. 2005/0023548 to Bhat et al., U.S. Pat. Pub. No. 2011/0101394 to McKenzie et al., U.S. Pat. No. 7,595,453 to Palmteer, and U.S. Pat. Pub. No. 2009/0103005 to Nakazato et al.

To facilitate soldering operations, through-holes, pads, lands and other points of connection are arranged so that they are receptive to the subsequent soldering processes. Thus, these surfaces must be readily wettable by the solder to permit an integral conductive connection with the leads or surfaces of the electronic components. Because of these needs, printed circuit fabricators have devised various methods of preserving and enhancing the solderability of these surfaces.

One means of providing good solderability of the surfaces in question is to provide the surfaces with a pre-coating of solder. In printed circuit fabrication, however, this method has several drawbacks. In particular, because it is not easy to selectively provide these areas with solder, all conductive areas of the board must be solder plated, which can cause severe problems with the subsequent application of solder mask.

Various attempts have been made to selectively apply solder to the necessary areas only. For example, U.S. Patent No. 4,978,423 involves the use of organic etch resists over the solder plated areas of connection followed by selective stripping of tin-lead from the copper traces before application of the solder mask. U.S. Pat. No. 5,160,579 describes other examples of known selective solder processes.

Soldering directly to copper surfaces can be difficult and inconsistent. These problems are due mainly to the inability to keep the copper surfaces clean and free of oxidation throughout the soldering operation. Various organic treatments have been developed to preserve copper surfaces in a readily solderable state. For example, U.S. Pat. No. 5,173,130 to Kinoshita describes the use of certain 2-alkylbenzimidazoles as copper pre-fluxes to preserve the solderability of the copper surfaces. Treatments such as those described by Kinoshita have proven successful but there is still a need to improve their reliability.

Another means of arranging good solderability of these surfaces is to plate them with a final finish coating of gold, palladium or rhodium. For example, U.S. Pat. No. 5,235,139 describes a method for achieving this metal final finish by plating the copper areas to be soldered with electroless nickel-boron, followed by a precious metal coating such as gold. In addition, U.S. Pat. No. 4,940,181 describes the plating of electroless copper, followed by electrolytic copper, followed by nickel followed by gold as a solderable surface and U.S. Pat. No. 6,776,828 describes the plating of electroless copper followed by immersion gold. These processes work well but are time consuming and relatively expensive.

Still another means of arranging good solderability of these surfaces is to electrolessly plate them with a final coating of silver. For example, U.S. Pat. No. 5,322,553 and U.S. Pat. No. 5,318,621 describe methods of treating copper clad printed circuit boards by coating them with electroless nickel then subsequently plating them with electroless silver. The electroless silver bath plates on a surface of a support metal to give a thick deposit.

As discussed in U.S. Pat. No. 6,773,757 and U.S. Pat. No. 5,935,640 immersion silver deposits are excellent solderability preservatives, which are particularly useful in the fabrication of printed circuit boards. Immersion plating is a process which results from a replacement reaction whereby the surface being plated dissolves into solution and at the same time the metal being plated deposits from the plating solution onto the surface. The immersion plating typically initiates without prior activation of the surfaces. The metal to be plated is generally more noble than the surface metal. Thus immersion plating is usually significantly easier to control and significantly more cost effective than electroless plating, which requires sophisticated autocatalytic plating solutions and processes for activation of the surfaces prior to plating.

The use of immersion silver deposits can be problematic because of the possibility of solder mask interface attack (SMIA) in which galvanic attack may erode the copper trace at the interface between the solder mask and the copper trace. SMIA is also referred to as solder mask crevice corrosion and galvanic attack at the solder mask interface. The problem concerns a galvanic attack at the solder mask-copper interface, and this interfacial galvanic attack arises as a result of the solder mask-copper interfacial structure and the immersion plating mechanism.

Galvanic corrosion is caused by the junction of two dissimilar metals. Differences in the metal can be seen as composition of the metal itself varying, or differences in grain boundaries, or localized shear or torque from the manufacturing process. Almost any lack of homogeneity of the metal surface or its environment may initiate a galvanic corrosion attack, causing a difference in potential. Contact between dissimilar metals also causes galvanic current to flow, due to the difference in potential of the two or more different metals. Galvanic corrosion can occur when one metal is coated with a more noble metal, for example silver over copper, and any exposed copper can accelerate this process as well. Higher failure rates and accelerated corrosion are seen in environments that have high levels of reduced sulfur gases such as elemental sulfur and hydrogen sulfide.

As described herein, the formation of a silver layer is also desirable in the manufacture of LEDs. As described, for example, in U.S. Pat. Pub. No. 2004/0256632 to Stein et al., it is desirable to form a reflective contact between an optoelectronic semiconductor chip, for example an LED, and a carrier substrate so that penetration of radiation generated or detected by the optoelectronic semiconductor chip into the contact is avoided and absorption losses are reduced. Stein describes arranging a very thin layer containing platinum, palladium, or nickel between a semiconductor layer containing a nitride compound and a reflective layer containing silver or gold. U.S. Pat. Pub. No. 2007/0145396 to Wantanabe describes improving the light extraction efficiency of an LED and thereby increase the life and power of the LED while decreasing power consumption, by arranging a light reflective layer comprising a silver alloy between a semiconductor layer, formed by laminating a first conductive layer, an active layer and a second conductive layer on a transparent substrate, and a protective layer. U.S. Pat. Pub. No. 2005/0023548 to Bhat et al. describes a mount for a flip chip semiconductor LED, such that the LED and submount are surface-mountable on another device by an interconnect. In addition, the submount has a solderable layer thereon.

While various methods have been suggested for treating metal surfaces to prevent corrosion thereon and/or increase reflectance of the treated metal surface, there remains a need for addition processes for preventing corrosion and/or increasing reflectance of treated metal surfaces.

WO 2010/113852 discloses a method of implementing a light emitting element on a light reflecting surface comprising the steps of laminating a copper foil on an insulating portion, electrolessly plating a layer of nickel on the copper foil, and electrolessly plating a layer of silver on the nickel layer.

### SUMMARY OF THE INVENTION

It is an object of the present invention to provide an improved means of reducing corrosion of underlying metal surfaces.

It is another object of the present invention to provide an improved means of preventing galvanic corrosion of such metal surfaces.

It is still another object of this invention to propose an improved means for preserving and enhancing the solderability of metal surfaces.

It is still another object of the invention to eliminate copper pores in silver deposits that are susceptible to tarnish and corrosion.

It is still another object of the invention to substantially eliminate migration of copper through silver deposits on printed circuit boards, electronic packaging and LEDs.

It is still another object of the invention to increase reflectance of silver surfaces during the manufacture of LEDs.

It is still another object of the present invention to provide a solderable silver surface on a substrate for mounting of an LED thereon.

To that end, the present invention relates to a process for mounting a LED on a wiring board recited in claim 1.

### DETAILED DESCRIPTION OF THE PREFERRED EMBODIMENTS

The present invention relates to a process for mounting a LED on a wiring board recited in claim 1.

In one aspect, the nickel plated on the metal surface comprises either from 2% to 12% by weight phosphorous or from 0.0005% to 0.1% by weight sulfur.

The metal surface may be any metal which is less electropositive than silver, including, for example, zinc, iron, tin, nickel, lead or copper and alloys of the foregoing. In a preferred embodiment, the metal surface is a copper or copper alloy surface.

Preferably, prior to contacting the metal surface with the plating composition compositions, the metal surface is cleaned. For example, cleaning may be accomplished using an acidic cleaning composition or other such cleaning composition that is well known in the art.

The nickel plating is preferably accomplished electrolessly but, in an aspect that is not claimed, it can also be plated electrolytically. Electroless nickel plating is an autocatalytic or chemical reduction of nickel ions to nickel which is then deposited on a substrate and can be used upon any metal surface upon which nickel can be plated.

In order to successfully plate nickel on certain metal surfaces, it may be necessary to activate the surfaces with a precious metal activator prior to contacting the surfaces with the electroless nickel plating bath. The precious metal activator typically comprises colloidal or ionic palladium, gold or silver and is performed before the electroless step.

For example, when the metal surface comprises copper or copper alloy, preparing the surface to accept electroless nickel plating thereon may comprise (i) a precious metal activator before an electroless nickel phosphorus bath, or (ii) use of a dimethylamino borane pre-dip to create a very thin nickel layer before an electroless nickel phosphorus bath. In either instance, an adherent and uniform deposit is formed on the metal surface.

Optionally, the metal surface may also be microetched to increase the magnitude and reliability of the subsequent bond. In the case of copper or copper alloy metal surfaces, the microetch may comprise (i) a peroxide-sulfuric microetch, (ii) a cupric chloride microetch, or (iii) a persulfate microetch. In each case, it is preferable for the microetch to uniformly roughen the metal surface. The time and temperature of the contact with the microetchant may vary depending, for example, upon the type of microetchant being used and the characteristics of the metal surface with the goal being the attainment of a uniformly rough metal surface.

After microetching, and before contact with the plating bath, the metal surface may be activated with a precious metal activator, as discussed above, to coat the metal surface with catalytic precious metal sites which are capable of initiating the subsequent electroless plating.

The metal surface is then contacted with an electroless nickel plating bath, preferably for a time and at a temperature sufficient to plate about 2 to about 50 microinches of nickel, more preferably from 2.5 to 6.4 micrometers (about 100 to about 250 microinches) of nickel.

In one aspect, a suitable electroless nickel plating bath for use in the present invention comprises:
a) a source of nickel ions;
b) a reducing agent;
c) a complexing agent;
d) one or more bath stabilizers; and
e) one or more additional additives.

The source of nickel ions can be any suitable source of nickel ions, and is preferably a nickel salt selected from the group consisting of nickel bromide, nickel fluoroborate, nickel sulfonate, nickel sulfamate, nickel alkyl sulfonate, nickel sulfate, nickel chloride, nickel acetate, nickel hypophosphite and combinations of one or more of the foregoing. In a preferred aspect the nickel salt is nickel sulfamate. In another preferred embodiment, the nickel salt is nickel sulfate.

Reducing agents typically include borohydride and hypophosphite ions. Typically, electroless nickel plating is carried out utilizing hypophosphite ions as the reducing agent, with sodium hypophosphite being the most preferable. Other reducing agents include sodium borohydride, dimethylamine borane, N-diethylamine borane, hydrazine and hydrogen, by way of example and not limitation.

The stabilizers in the solution may be metallic (inorganic) or organic. Metallic stabilizers commonly used in electroless nickel plating solutions include Pb, Sn, or Mo compounds, such as lead acetate. Organic stabilizers commonly used include sulfur compounds ("S compounds"), such as thiourea. Complexing agents include citric acid, lactic acid, or malic acid. Sodium hydroxide may also be included in the electroless nickel bath to maintain the pH of the solution.

As described herein the electroless nickel plating solution may include one or more additives selected from sulfur and/or phosphorus. Sulfur is preferably usable in the plating solution as a divalent sulfur and phosphorus is typically usable in the plating solution as a hypophosphite. If divalent sulfur is present in the electroless nickel plating solution, it is preferable that it be present at a concentration of about 0.1 ppm to about 3ppm, most preferably from about 0.2 ppm to about 1 ppm, not including the sulfur present from the source of acidity such as sulfuric acid, sulfuric acid or methane sulfonic acid. Furthermore, the inventors have found that if nickel sulfamate is used as the nickel salt in accordance with the present invention, at least a minimal amount of sulfur and/or phosphorus should be included in the electroless nickel plating bath. In a particularly preferred aspect, the nickel plated on the metal surface comprise about 2 percent by weight to about 12 percent by weight phosphorus and/or 0.0005% by weight sulfur to 0.1% by weight sulfur. It has unexpectedly been found that the inclusion of the foregoing amounts of phosphorous and/or sulfur are beneficial to achieving an improved immersion silver deposit.

Nickel ions are reduced to nickel in the electroless nickel plating bath by the action of chemical reducing agents which are oxidized in the process. The catalyst may be the substrate or a metallic surface on the substrate, which allows the reduction-oxidation reaction to occur with the ultimate deposition of nickel on the substrate.

The electroless plating deposition rate is further controlled by selecting the proper temperature, pH and metal ion/reducer concentrations. Complexing agents may also be used as catalyst inhibitors to reduce the potential for spontaneous decomposition of the electroless bath.

The total thickness of electroless nickel plated on the metal surface is typically in the range of about 0.025 to 13 micrometers (1 to 500 microinches), preferably in the range of 2.5 to 6.4 micrometers (about 100 to about 250 microinches).

Once a layer of electroless nickel has been plated on the metal surface, the electroless nickel plated metal surface is thereafter immersion silver plated to provide a layer of silver thereon. As discussed above, immersion silver deposits are excellent solderability preservatives and are particularly useful in the fabrication of printed circuit boards. The solderability achieved by following electroless nickel plating with immersion silver plating in accordance with the present invention results in an unexpectedly large reduction of galvanic corrosion on the surfaces of the circuits, a reduction of copper pores which are susceptible to tarnish and corrosion, and an increase in the process window for bonding applications. This is beneficial because, in printed circuit applications, for example, the surfaces are wire bondable. Additionally, the process of the present invention results in uniform silver coverage and increased reflectance of the silver surface.

The immersion silver plating bath of the present invention comprises:
a) a soluble source of silver ions;
b) an acid;
c) an oxidant; and
d) optionally, but preferably, an imidazole or imidazole derivative.

The silver immersion plating solution contains a soluble source of silver ions in an acid aqueous matrix. The soluble source of silver ions can be derived from a variety of silver compounds, including for example organic or inorganic silver salts. In a preferred embodiment, the source of silver ions is silver nitrate. The concentration of silver in the plating solution can generally range from about 0.1 to 25 grams per liter, but is preferably in the range of about 0.5 to 2 grams per liter.

A variety of acids are suitable for use in the silver immersion plating solution, including, for example, fluoboric acid, hydrochloric acid, phosphoric acid, methane sulfonic acid, nitric acid and combinations of one or more of the foregoing. In one embodiment, methane sulfonic acid or nitric acid is used. The concentration of acid in the plating solution generally ranges from about 1 to 150 grams per liter but is preferably in the range of about 5 to 50 grams per liter.

The silver immersion plating solution also comprises an oxidant in order to create a uniform silver covering on the electroless nickel plated substrate. According to the invention, nitro aromatic compounds such as sodium meta-nitrobenzenesulfonate, para-nitrophenol, 3,5-dinitrosalicylic acid, and 3,5-dinitrobenzoic acid are used

in this regard. In a preferred embodiment, the dinitro compound is 3,5-dinitrosalicylic acid. The concentration of the oxidant in the solution can range from about 0.1 to 25 grams per liter, but is preferably from about 0.5 to 2 grams per liter.

In order to further reduce the tendency for immersion silver plates to electromigrate in the application proposed, certain additives may also be included in the plated deposit, either by incorporation of the additives in the plating bath itself or by subsequent treatment of the plated surface with the additives. These additives may be selected from the group consisting of fatty amines, fatty acids, fatty amides, quaternary salts, amphoteric salts, resinous amines, resinous amides, resinous acids and mixtures of the foregoing. Examples of the additives are described, for example, in U.S. Patent No. 7,267,259. The concentration of the foregoing additives in the immersion silver plating bath or in the subsequent surface treatment composition typically range from 0.1 to 15 grams per liter but is preferably from 1 to 5 grams per liter.

In addition, as described in U.S. Pat. No. 7,631,798, an imidazole or imidazole derivative may also optionally be included in the immersion plating bath of the present invention to make the plate brighter, smoother and more cohesive.

The immersion silver plating bath is typically maintained at a temperature of about room temperature to about 93° C (200° F), more preferably at about 27° C (80° F) to about 49° C (120° F). The article to be plated may be immersed in the plating solution for a suitable amount of time to achieve the desired plating thickness of the deposit, which is typically in the range of about 1 to 5 minutes.

The immersion silver solution plates a thin layer of silver onto the metal surface. According to the invention, the resultant silver coating is from about 0.025 to 2.5 micrometres (1 to 100 micro inches) thick, preferably from about 0.25 to 1.5 micrometres (10 to 60 micro inches) thick for effective enhancement and preservation of the solderability of the surface.

Although the process described herein is effective in soldering various metal surfaces, it is particularly useful in soldering copper surfaces, such as Areas of Connection on electronic packaging devices such as printed circuit boards. By preventing corrosion on the printed circuit boards, the useful life of the device can be extended. Furthermore, by eliminating corrosion, soldering problems can be substantially eliminated, which is a major benefit for board, circuit and component manufacturers.

In an aspect that is not claimed, the process described herein is also effective in silver plating LEDs and in preparing LEDs to accept soldering thereon, for example for soldering to electronic packaging devices including printed circuit boards. Patterning of electrical contacts may be accomplished by wet-chemical patterning as is generally known in the art. It is possible for copper to migrate through silver deposits as a function of heat in LED applications, thus decreasing the surface reflectance. Thus, the process described herein produces a surface in which copper migration through the silver deposit is at least substantially eliminated resulting in increased reflectivity, which is particularly beneficial for use in LED applications. In one embodiment, the process described herein provides a silver surface on an LED with a reflectance of at least 80 percent.

U.S. Pat. Pub. No. 2005/0023548 to Bhat describes an example of a submount on which an LED is mounted having electrical contacts on the side opposite the LED, such that the LED and submount are surface-mountable on another device, such as a printed circuit board.

Electrical contacts for the die of the light emitting device may be formed by coupling interconnects to the die. The interconnects may be made of solder balls, elemental metals, metal alloys, semiconductor-metal alloys, solders, thermally and electrically conductive pastes or compounds (e.g., epoxies), eutectic joints (e.g., Pd--In--Pd) between dissimilar metals between the LED die and submount, Au stud-bumps, or configurations of solder besides balls, such as bars.

The solder balls or other interconnects are electrically coupled to conductive surfaces on the surface-mountable submount which may be connected to another structure by, for example, solder joints. Conductive surfaces are typically solderable layers or surfaces and are connected to other devices by solder joints. The solder joints include the solderable layers formed on the submount. The solderable layers can be formed on at least two surfaces of the submount, and, in some embodiments, the solderable layers cover opposite surfaces of the submount, such as the top and the bottom surfaces. The solderable surfaces may also extend around side surfaces of the submount, connecting the top and bottom solderable surfaces. These designs provide large solderable surfaces, to which the solders can be soldered. Solders may contact the solderable surfaces on just the bottom of submount, or may extend up the sides of submount when solderable surfaces are provided on the sides of submount. The solders are electrically coupled to the package leads which are formed on a board such as a printed wiring board. The package leads can be formed in various ways, for example, by covering more than one surface of the wiring board. Finally, one or more surfaces of submount and the printed circuit board facing the LED may be reflective.

The solder connections also provide an efficient channel to conduct heat away from the LED. Other ways of dissipating heat are described, for example, in U.S. Pat. Pub. No. 2009/0267085.

The submount can be formed from, for example, Si, SiC, sapphire, PCB, AlNₓ, Al₂O₃, or any other material known in the art. The solder can be, for example, an alloy containing Sn such as PbSn-- or AgSn-- binaries, ternaries, and quaternaries; an alloy containing Au such as AuSn or AuGe binaries; an alloy containing one or more of the following: In, Bi, Pb, Sb, Ag, Cu; or a metal such as Au, Ag, In, Sn, Pb, Bi, Ni, Pd, or Cu. The solderable layer can be, for example, gold, silver, nickel, copper, platinum, or other materials known in the art.

For purposes of the present invention, the inventors have found that the solderable layer on the submount may beneficially comprise a copper or copper alloy that can be processed in the manner described herein to provide a nickel plated layer and an immersion silver plated layer thereon. The use of the nickel and silver plating layers on top of the copper layer produces a deposit that improves the corrosion resistance of the underlying copper layer and improves the reflectance of the silver layer. The use of the nickel and silver layers on the copper layer also serves to improve the solderability of the submount to the LED subsequently attached thereto.

The light emitting diode is coupled to the submount instead of the wiring board directly for several reasons. For example, the submount contributes to good light reflection of the device. In addition, smaller features may be formed on a submount than on a wiring board, potentially reducing the size of the device and improving the heat extraction capabilities of the device. In addition, as described for example in U.S. Patent Pub. No. 2009/0053840 to Chou et al., the light emitting surface of the LED may be sealed and encapsulated by a transparent material which can be a transparent resin or epoxy resin. Thus, in one embodiment, the light emitting diode and at least a portion of the nickel silver contact may be encapsulated by a transparent material.

The process of the present invention has also been shown to at least substantially eliminate galvanic corrosion from the underlying copper substrate. In addition, the process of the present invention substantially eliminates copper pores in the silver deposit that are susceptible to tarnish corrosion and further at least substantially eliminates migration of copper through the silver deposit. As a result, the process of the present invention also increases the processing window for wire bonding applications because any oxidized copper encountered during wire bonding results in a non-bondable surface.

Finally, while the present invention as described herein utilizes electroless nickel, it is also possible that the electroless nickel plating bath may comprise a nickel alloy or, in the alternative, in an aspect that is not claimed, that the nickel barrier can be provided using an electrolytic nickel deposit or, another suitable electroless plating metal may be used in place of electroless nickel.

## Claims

1. A process for mounting a light emitting diode (LED)
on a wiring board, the process comprising the steps of:
a) providing a submount configured for coupling to a wiring board and configured for having coupled thereto a light emitting diode;
b) forming a contact on at least a portion of a metal surface of the submount, the contact being formed by the steps of:
i) preparing at least the portion of the metal surface of the submount to accept electroless nickel plating thereon;
ii) depositing a nickel layer on at least the portion of the metal surface of the submount by an electroless nickel deposition process; and thereafter
iii) depositing a silver layer on the electroless nickel layer using an electroless immersion silver plating solution, wherein the immersion silver plating solution comprises:
a soluble source of silver ions;
an acid; and
an oxidant, wherein the oxidant comprises one or more nitro aromatic compounds;
wherein the silver layer has a thickness of 0.025 to 2.5 micrometres (1 to 100 microinches); and
wherein a reflective nickel-silver contact is formed on at least the portion of the metal surface of the submount that provides a solderable surface for mounting of the light emitting diode thereon;
c) coupling a light emitting diode to the nickel-silver layers; and
d) coupling the submount to a wiring board by soldering the submount to package leads formed on the wiring board.

2. The process according to claim 1, wherein the metal surface of the submount comprises a metal that is less electropositive than silver,
optionally wherein the metal surface is a copper or copper alloy surface.

3. The process according to claim 1, wherein the metal surface is also patterned to form at least one contact area, pad, land, area of connection, electrode or combinations of one or more of the foregoing on the submount.

4. The process according to claim 1, wherein the light emitting diode is a flip-chip light emitting diode.

5. The process according to claim 1, further comprising the step of encapsulating the light emitting diode and at least a portion of the nickel-silver contact.

6. The process according to claim 1, further comprising mounting a plurality of light emitting diodes on the nickel-silver contact, optionally wherein at least some of the plurality of light emitting diodes are connected in series.

7. The process according to claim 1, wherein a bottom metal layer of the light emitting diode is bonded to the nickel-silver contact.

8. The process according to claim 1, wherein the silver layer has a thickness of between about 0.25 to 1.5 micrometres (10 to 60 microinches).

## Patentansprüche

1. Verfahren zum Montieren einer Leuchtdiode (LED) auf einer Leiterplatte, wobei das Verfahren die folgenden Schritte umfasst:
a) Bereitstellen eines Subträgers, der zum Koppeln mit einer Leiterplatte konfiguriert ist und dazu konfiguriert ist, eine Leuchtdiode daran gekoppelt zu haben;
b) Bilden eines Kontakts auf mindestens einem Abschnitt einer Metalloberfläche des Subträgers, wobei der Kontakt durch die folgenden Schritte gebildet wird:
i) Vorbereiten mindestens des Abschnitts der Metalloberfläche des Subträgers, um eine stromlose Nickelplattierung darauf aufzunehmen;
ii) Abscheiden einer Nickelschicht auf mindestens dem Abschnitt der Metalloberfläche des Subträgers durch ein stromloses Nickelabscheidungsverfahren; und danach
iii) Abscheiden einer Silberschicht auf der stromlosen Nickelschicht unter Verwendung einer stromlosen Silbertauchplattierungslösung, wobei die Silbertauchplattierungslösung Folgendes umfasst:
eine lösliche Silberionenquelle;
eine Säure; und
ein Oxidationsmittel, wobei das Oxidationsmittel eine oder mehrere nitroaromatische Verbindungen umfasst;
wobei die Silberschicht eine Dicke von 0,025 bis 2,5 Mikrometern (1 bis 100 Mikrozoll) aufweist; und
wobei ein reflektierender Nickel-Silber-Kontakt auf mindestens dem Abschnitt der Metalloberfläche des Subträgers gebildet ist, der eine lötbare Oberfläche zum Montieren der Leuchtdiode darauf bereitstellt;
c) Koppeln einer Leuchtdiode mit den Nickel-Silber-Schichten; und
d) Koppeln des Subträgers mit einer Leiterplatte durch Löten des Subträgers an Gehäuseanschlüsse, die auf der Leiterplatte ausgebildet sind.

2. Verfahren nach Anspruch 1, wobei die Metalloberfläche des Subträgers ein Metall umfasst, das weniger elektropositiv als Silber ist,
optional wobei die Metalloberfläche eine Kupfer- oder Kupferlegierungsoberfläche ist.

3. Verfahren nach Anspruch 1, wobei die Metalloberfläche auch strukturiert wird, um mindestens einen Kontaktbereich, eine Kontaktfläche, einen Steg, einen Verbindungsbereich, eine Elektrode oder Kombinationen von einem oder mehreren der Vorstehenden auf dem Subträger zu bilden.

4. Verfahren nach Anspruch 1, wobei die Leuchtdiode eine Flip-Chip-Leuchtdiode ist.

5. Verfahren nach Anspruch 1, ferner umfassend den Schritt des Einkapselns der Leuchtdiode und mindestens eines Abschnitts des Nickel-Silber-Kontakts.

6. Verfahren nach Anspruch 1, ferner umfassend das Montieren einer Vielzahl von Leuchtdioden auf dem Nickel-Silber-Kontakt, wobei optional mindestens einige der Vielzahl von Leuchtdioden in Reihe geschaltet sind.

7. Verfahren nach Anspruch 1, wobei eine untere Metallschicht der Leuchtdiode an den Nickel-Silber-Kontakt gebondet wird.

8. Verfahren nach Anspruch 1, wobei die Silberschicht eine Dicke zwischen etwa 0,25 und 1,5 Mikrometer (10 bis 60 Mikrozoll) aufweist.

## Revendications

1. Procédé de montage d'une diode électroluminescente (DEL) sur une carte de câblage, le procédé comprenant les étapes consistant à :
a) fournir un sous-ensemble configuré pour être couplé à une carte de câblage et configuré pour qu'une diode électroluminescente y soit couplée ;
b) former un contact sur au moins une partie d'une surface métallique du sous-montage, le contact étant formé par les étapes consistant à :
i) préparer au moins la partie de la surface métallique du sous-montage pour accepter un dépôt autocatalytique de nickel sur celle-ci ;
ii) déposer une couche de nickel sur au moins la partie de la surface métallique du sous-montage par un processus de dépôt autocatalytique de nickel ; et par la suite
iii) déposer une couche d'argent sur la couche de nickel autocatalytique en utilisant une solution de placage d'argent par immersion autocatalytique, dans lequel la solution de placage d'argent par immersion comprend :
une source soluble d'ions argent ;
un acide ; et
un oxydant, où l'oxydant comprend un ou plusieurs composés aromatiques nitro ;
dans lequel la couche d'argent a une épaisseur de 0,025 à 2,5 micromètres (1 à 100 micro-pouces) ; et
dans lequel un contact réfléchissant de nickel-argent est formé sur au moins la partie de la surface métallique du sous-montage qui fournit une surface pouvant être soudée pour montage de la diode électroluminescente sur celle-ci ;
c) coupler une diode électroluminescente aux couches nickel-argent ; et
d) coupler le sous-montage à une carte de câblage en soudant le sous-montage à des câbles de conditionnement formés sur la carte de câblage.

2. Procédé selon la revendication 1, dans lequel la surface métallique du sous-montage comprend un métal qui est moins électropositif que l'argent,
éventuellement dans lequel la surface métallique est une surface en cuivre ou en alliage de cuivre.

3. Procédé selon la revendication 1, dans lequel la surface métallique est également structurée pour former au moins une zone de contact, un tampon, un méplat, une zone de raccordement, une électrode ou des combinaisons d'un ou plusieurs de ce qui précède sur le sous-montage.

4. Procédé selon la revendication 1, dans lequel la diode électroluminescente est une diode électroluminescente "flip-chip".

5. Procédé selon la revendication 1, comprenant en outre l'étape d'encapsulation de la diode électroluminescente et au moins une partie du contact nickel-argent.

6. Procédé selon la revendication 1, comprenant en outre le montage d'une pluralité de diodes électroluminescentes sur le contact nickel-argent, éventuellement dans lequel au moins certaines de la pluralité de diodes électroluminescentes sont connectées en série.

7. Procédé selon la revendication 1, dans lequel une couche métallique inférieure de la diode électroluminescente est liée au contact nickel-argent.

8. Procédé selon la revendication 1, dans lequel la couche d'argent a une épaisseur comprise entre environ 0,25 et 1,5 micromètre (10 à 60 micro-pouces).
